# EUROPEAN PATENT SPECIFICATION

(11) **EP 3 767 310 B1**
(45) Date of publication and mention of the grant of the patent: **09.08.2023**
(21) Application number: 20182615.3
(22) Date of filing: 26.06.2020
(51) Int. Cl.: G01R 15/20

(54) **CURRENT SENSOR**
STROMSENSOR
CAPTEUR DE COURANT

(30) Priority: 01.07.2019 JP 2019123194
(43) Date of publication of application: 20.01.2021
(73) Proprietor: Tamura Corporation, Tokyo 178-8511 (JP)
(72) Inventor: HASHIMOTO, Makoto, Saitama, 350-0214 (JP); MONMA, Akio, Saitama, 350-0214 (JP); TATSUZUE, Hiroshi, Saitama, 350-0214 (JP); YU, Konghui, Saitama, 350-0214 (JP)
(74) Representative: Plougmann Vingtoft a/s

(56) References cited:
- CN-A- 106 556 730
- DE-U1-202015 104 233
- US-A1- 2013 162 246
- US-A1- 2014 167 750

## Description

### Technical Field

The present invention relates to a current sensor which converges a magnetic field generated by continuity of a current to be sensed on a core to sense the current.

### Background Art

A current sensor mentioned in the publication (JP2012-068158A1) issued by Japan Patent Office has a structure in which a magnetic sensor is disposed in a gap formed in an annular core. In more detail, in the structure of the current sensor, a container shaped member is interposed in the gap of the core housed in a casing, and the casing is filled with a mold member made of resin so as to seal the core inside in a state where an opening end portion of the container shaped member is exposed to the outside, thereby fixing the core in the desired position.

In particular, the above-described current sensor is considered to be capable of preventing a stress from acting on the magnetic sensor even though expansion and shrinkage caused by temperature changes of the mold member occur since an inner space of the container shaped member interposed in the gap of the core becomes a space where the mold member made of resin is not present.

However, in such a case of the structure in which the position of the core is fixed by the mold member filled in the casing as that of the above-described current sensor, factors of unevenness of a filling amount and a filling density, uneven quality of the resin, and the like cause the position where the core is finally fixed after resin curing not to be fixed, resulting in causing a variation for each individual product. Further, when the fixed position of the core varies, a position in the gap is not stable also regarding a Hall element to be inserted into the gap, and therefore sensing accuracy of the Hall element varies greatly for each product even in a magnetic flux under the same conditions.

DE 20 2015 104233 U1 discloses a housing for a current sensor with a circumferential outer wall 1, and furthermore a circumferential inner wall 2 arranged therein, through which an inner passage opening 7 is formed, the outer wall 1 with the inner wall 2 via a rear wall 6 is connected, characterized in that two spacers 4, 4 ' for positioning two magnetic cores 8, 8' are arranged inside the housing 10.

US 2014/167750 A1 discloses a current sensor includes: a lower housing; a lower magnetic core that is housed in the lower housing, and includes a first gap on which a first hall element for detection of a magnetic field is arrangeable; a central housing that detachably engages with the lower housing, and houses the lower magnetic core along with the lower housing; an upper magnetic core that is arranged on the central housing, and forms a ring structure for surrounding a conductor along with the lower magnetic core; and an upper housing that detachably engages with the central housing, and houses the upper magnetic core along with the central housing.

CN 106 556 730 A discloses a current sensor and a measuring apparatus. The current sensor includes a magnetic induction unit and a processing unit provided on the outside of the wire to be measured, the magnetic induction unit is used for sensing a magnetic field generated by a current flowing through the wire to be measured and obtaining an induced signal corresponding to magnetic field intensity; the input end of the processing unit is electrically connected with the output end of the magnetic induction unit to process the induced signal, and at least one pair of magnetic induction units are arranged on the outside of the wire to be measured, the processing unit obtains the value of the current flowing through the measured wire through differential operation based on the paired induced signals. The current sensor is high in measurement accuracy, high in antiinterference capability, and low in installation requirement.

US 2013/162246 A1 discloses that in a current detecting apparatus, a container member includes a substrate fixing portion, a core inner-edge positioning portions, and a lid member. The substrate fixing portion is a portion formed at a position outside an outer edge of a magnetic core, and to which a first portion of a circuit board is fixed. Two of the core inner-edge positioning portions come into contact with the magnetic core, and come into contact with the circuit board. The first portion, the second portion, and the third portion surround a magnetoelectric device, such as a Hall element, that detects a magnetic flux in a gap portion of the magnetic core. The lid-side substrate holding portion, with the container-side substrate holding portion, holds the circuit board tightly.

### Summary of the invention

It is an object of the present invention to achieve a structure in which a core is positioned.

The present invention provides a current sensor. The current sensor of the present invention includes a plurality of core members and a case body. The plurality of core members form a converging path of a magnetic field generated by continuity of a current to be sensed by providing gaps in respective spaces between end surfaces facing each other in a plurality of sections to be disposed in an annular shape. Further, the case body disposes and houses the plurality of core members in an annular shape. Thus, in a state of only disposing the core members, though the gaps are formed, the core members are not yet properly positioned. That is, in the core members, the respective end surfaces face each other to form the gaps, but when a positional relationship therebetween is displaced in the facing directions, a distance between the end surfaces is not fixed, resulting in that a gap distance is not held as specified.

Thus, the current sensor of the present invention includes a positioning member according to claim 1. These features of the positioning member cause the plurality of core members to be positioned in a state of holding the gap distance between the end surfaces facing each other as specified. In particular, since the plurality of core members are biased (i.e. pressed) in the facing directions, it is possible to securely prevent the positions from being displaced also after positioning and continue to stably keep the predetermined positions.

Preferably, the current sensor of the present invention includes holding members. The holding members hold the gaps in the specified distance by being sandwiched in the spaces between the end surfaces of the plurality of core members in a state of being biased by the positioning member. This makes it possible to continue to stably maintain a gap distance without biasing force caused by the positioning member acting in a direction of narrowing the gap distance from the specified one.

Further, the case body can include guide parts. The guide parts position the plurality of core members in directions crossing the directions facing them and confront the end surfaces with each other along the converging path, while guiding the plurality of core members at outer peripheral edges accompanying housing of the plurality of core members.

The above-mentioned positioning member makes the gap distance the same as specified by positioning in the facing directions of the core members, but unless the facing end surfaces of the core members stably and properly come face to face with each other, a magnetic flux passing through in the gaps leaks and is not stable even though the distance of the gaps is the specified one, resulting in causing variations in sensing accuracy.

The above-described guide parts position the plurality of core members housed in the case body in a state where the end surfaces face each other in each of originally confronting positions. This makes the magnetic flux passing through the gaps stable, and allows variations in the sensing accuracy to be further suppressed.

### Brief description of the drawings

In the drawings used in the description of an embodiment:
FIG. 1A and FIG. 1B are perspective views illustrating an assembly state of a current sensor of one embodiment;
FIG. 2 is an exploded perspective view schematically illustrating a configuration of the current sensor of one embodiment;
FIG. 3 is an exploded perspective view schematically illustrating the configuration of the current sensor of one embodiment;
FIG. 4A and FIG. 4B are perspective views illustrating an internal structure of a case body;
FIG. 5A and FIG. 5B are perspective views illustrating a disposition of inter-gap spacers in the case body;
FIG. 6A and FIG. 6B are perspective views illustrating a disposition of a magnetic core (core members) in the case body;
FIG. 7 is a front view illustrating the disposition of the magnetic core housed in the case body;
FIG. 8A and FIG. 8B are sectional views taken along a VIII-VIII line in FIG. 7;
FIG. 9A and FIG. 9B are perspective views illustrating a disposition of a positioning spacer with respect to the magnetic core in the case body;
FIG. 10 is a front view illustrating the disposition of the positioning spacer housed in the case body;
FIG. 11 is an exploded perspective view illustrating a state of separating the positioning spacer from the case body and the core members;
FIG. 12 is a sectional view taken along a XII-XII line in FIG. 10;
FIG. 13A and FIG. 13B are sectional views taken along a XIII-XIII line in FIG. 10;
FIG. 14A to FIG. 14C are sectional views taken along a XIV-XIV line in FIG. 10;
FIG. 15A and FIG. 15B are views explaining positioning of the core members by using the positioning spacer;
FIG. 16A and FIG. 16B are perspective views illustrating a disposition of a circuit board in the case body;
FIG. 17 is a front view of the current sensor including the circuit board;
FIG. 18 is a view illustrating the circuit board in an assembly process of the current sensor in a state in the middle of mounting; and
FIG. 19A and FIG. 19B are views illustrating the circuit board in the assembly process of the current sensor in the state in the middle of the mounting.

### Preferred embodiments

Hereinafter, an embodiment of the present invention will be described with reference to the drawings. In the following embodiment, a magnetic-proportional-type current sensor is cited as one example of a current sensor, but the present invention is not limited to this, and a magnetic-balance-type current sensor is applicable or a flux-gate-type current sensor is applicable.

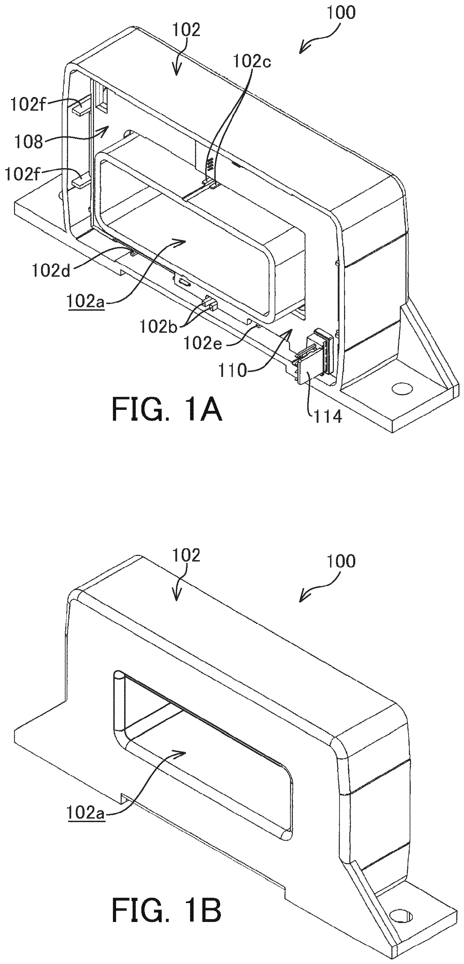

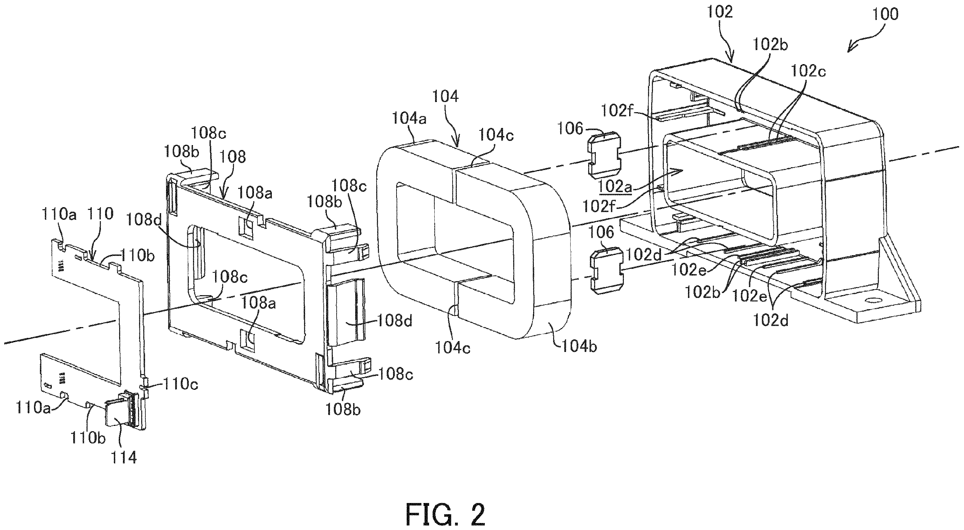

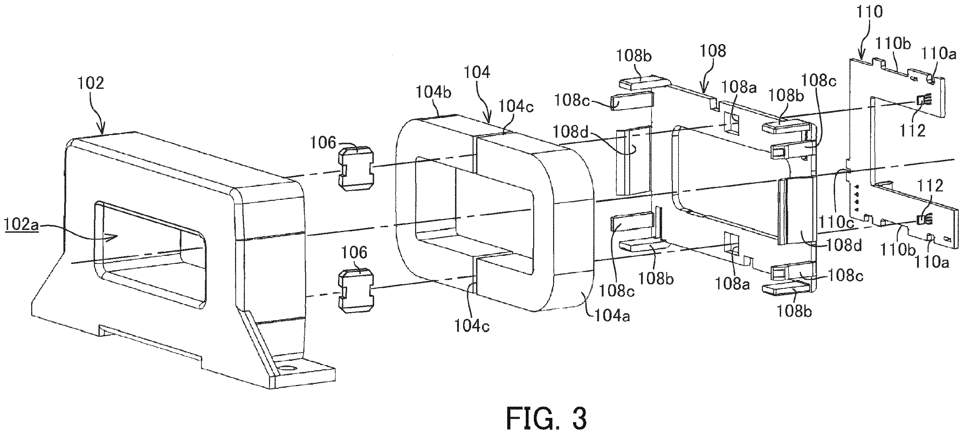

FIG. 1A and FIG. 1B are perspective views illustrating an assembly state of a current sensor 100 of one embodiment. Further, FIG. 2 and FIG. 3 are exploded perspective views schematically illustrating a configuration of the current sensor 100 of one embodiment. Note that when the current sensor 100 illustrated in FIG. 1A is illustrated from a different direction (180° to the opposite side), the perspective view in FIG. 1B is obtained. Further, obliquely viewed directions are inverted between FIG. 2 and FIG. 3.

### [Overall configuration]

As illustrated in FIG. 2 and FIG. 3, the current sensor 100 mainly includes a case body 102, a magnetic core 104, inter-gap spacers 106, a positioning spacer 108, and a circuit board 110, and has a form of usage as illustrated in FIG. 1A and FIG. 1B in a state of housing the magnetic core 104, the inter-gap spacers 106, the positioning spacer 108, and the circuit board 110 in the case body 102. FIG. 1A to FIG. 3 illustrate the current sensor 100 in a posture of supposing the form of usage, and the form of usage supposes that a not illustrated conductor (a bus bar or the like) which conducts a current to be sensed is inserted through in a lateral direction (horizontal direction). Note that the current sensor 100 may be in a form used in the other postures (for example, a flat placement posture, a laid-on-end posture, an inverted posture, and the like).

### [Case body]

The case body 102 is formed in a rectangular container shape in which one end surface is open and the other end surface is close. Further, the case body 102 is formed with a rectangular through hole 102a in the center thereof, and a container shape of the case body 102 is thus formed in a rectangular annular shape as a whole. The through hole 102a passes through the center of the current sensor 100 in a thickness direction in the assembly state, and the not illustrated conductor described above is inserted through in the lateral direction (horizontal direction) in the through hole 102a in a standing posture of the current sensor 100 illustrated in FIG. 1. For this purpose, on the case body 102, flanges (no reference sign) for placing the current sensor 100 in the standing posture are integrally formed. Note that an internal structure of the case body 102 (many ribs given signs in the views) is described later.

### [Core member, Magnetic core]

The magnetic core 104 is formed in a rectangular annular shape as a whole. The magnetic core 104 is composed of paired core members 104a, 104b. The pair of core members 104a, 104b is individually formed in lateral U shapes (so-called U-U type), and disposed in an annular shape in a state of facing both tip surfaces of the U shapes with each other, to compose one magnetic core 104. At this time, gaps 104c are formed in spaces between end surfaces of the pair of core members 104a, 104b (two sections). A soft magnetic material (for example, ferrite, silicon steel, or the like) is used for the core members 104a, 104b, and when the not illustrated conductor conducts the current to be sensed, a magnetic field generated therearound is converged on the magnetic core 104. The magnetic core 104 forms a converging path of the magnetic field (magnetic circuit, magnetic path, magnetic flux path) in its circumferential direction at this time.

### [Holding member]

The inter-gap spacers 106 are each composed of, for example, a thin sheet material made of resin. The inter-gap spacers 106 are interposed and disposed in the gaps 104c of the magnetic core 104 respectively. The inter-gap spacers 106 hold the gaps 104c in a specified distance in a state of being sandwiched in the spaces between the end surfaces of the pair of core members 104a, 104b. Concretely, the inter-gap spacers 106 can hold the distance of the gaps 104c with a dimension corresponding to their thickness set as a specified dimension.

### [Positioning member]

The positioning spacer 108 is formed in an annular shape (rectangular shape with a vacant hole) fitted to one end surface opening of the case body 102 and one side surface of the magnetic core 104. Further, the positioning spacer 108 is formed with a pair of openings 108a in a plate-shaped portion (no reference sign) formed in the annular shape, in addition to which formed with four each of leg portions 108b and hooking claws 108c at peripheral edges (four corners) of the plate-shaped portion, and formed with spring portions 108d at facing both side edges. These leg portions 108b, hooking claws 108c, and spring portions 108d extend from the plate-shaped portion toward the inside of the case body 102, and in the assembly state of the current sensor 100, the leg portions 108b, the hooking claws 108c, and the spring portions 108d are disposed between an outer peripheral surface of the magnetic core 104 and an inner surface of the case body 102. For this reason, the positioning spacer 108 is housed in the case body 102 so as to cover the one side surface and the outer peripheral surface of the magnetic core 104 from one end surface opening side of the case body 102. In the housed state, the positioning spacer 108 positions the magnetic core 104 in a predetermined position. Note that the positioning by using the positioning spacer 108 is further described later.

### [Circuit board]

The circuit board 110 is also formed in a shape fitted to the one end surface opening of the case body 102 and the one side surface of the magnetic core 104, but is not connected in an annular shape, and has a mounting surface in a ⊐ shape such that a rectangular shape with a vacant hole is halved. Two Hall elements 112 are through-hole mounted as magnetic sensing elements on one mounting surface, and a connector 114 is through-hole mounted on the other mounting surface. In the assembly state of the current sensor 110, the circuit board 110 is housed in the case body 102 so as to be put on one side surface of the positioning spacer 108. In the housed state, the two Hall elements 112 are disposed through the openings 108a of the positioning spacer 108 in the gaps 104c of the magnetic core 104. On the circuit board 110, a circuit for sensing the current to be sensed by using magnetic sensing signals of the Hall elements 112 is formed. For this reason, various kinds of electronic components (a chip component, an IC, and the like) which are not illustrated are mounted on the respective mounting surfaces of the circuit board 110, and on the respective mounting surfaces and in an inner layer, various kinds of wiring patterns and via holes are formed. Note that the circuit board 110 may be formed in an annular shape.

### [Internal structure]

Next, the internal structure of the case body 102 will be described.

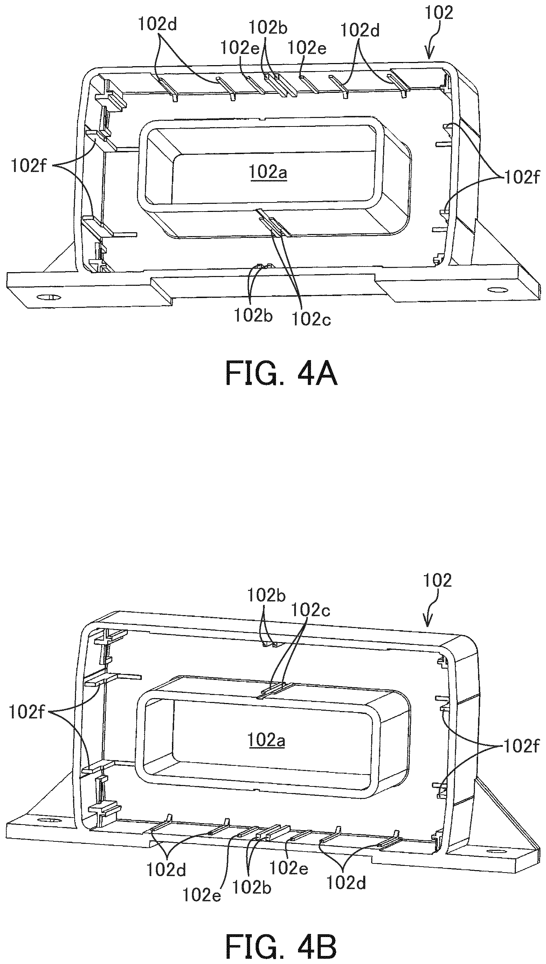

FIG. 4A and FIG. 4B are perspective views illustrating the internal structure of the case body 102. For convenience of visual recognition, directions of obliquely viewing the case body 102 are made different between FIG. 4A and FIG. 4B. Note that in the following description, for convenience, of a rectangle seen from one end surface opening side of the case body 102 in the form of usage (standing posture in FIG. 1) of the current sensor 100, a long-length direction is set as a long side direction (lateral direction), and a short-length direction is set as a short side direction (vertical direction).

Since the case body 102 is formed with the through hole 102a in the center thereof as described above, its periphery is surrounded by a rectangular inner peripheral wall (no reference sign). Then, a housing space is surrounded by a rectangular outer peripheral wall (no reference sign) apart from the inner peripheral wall, and many ribs are formed on an inner surface of the outer peripheral wall and an outer surface (inner side for the case body 102) of the inner peripheral wall. Note that any of many ribs extends in a stripe shape from the other end side surface toward the one end surface opening of the case body 102.

Concretely, first, at each of the middle positions seen in the long side direction, two stripes of gap position ribs 102b, 102c paired in the short side direction are formed. Between them, each two stripes of the gap position ribs 102b are formed on each of the inner surfaces of the outer peripheral wall which face each other in the short side direction, and each two stripes of the gap position ribs 102c are formed on each of the outer surfaces of the inner peripheral wall which face each other. Note that on each of the outer surfaces of the inner peripheral wall, a groove (no reference sign) is formed between the gap position ribs 102c.

Next, at positions apart to some extent from the gap position ribs 102b to the respective both sides in the long side direction, intermediate ribs 102e paired in the short side direction are formed on the inner surfaces of the outer peripheral wall. Further, at positions apart on both sides of the intermediate ribs 102e in the long side direction, guide ribs 102d paired in the short side direction are formed, and moreover at positions apart on both sides thereof, guide ribs 102d paired in the short side direction are also formed. Note that the intermediate ribs 102e and the guide ribs 102d are formed on only the inner surfaces of the outer peripheral wall.

The above describes the ribs formed on the inner surfaces extending in the long side direction, and ribs are also formed on inner surfaces extending in the short side direction. Concretely, on each of the inner surfaces of the outer peripheral wall which face each other in the long side direction, each two stripes of two-paired auxiliary ribs 102f are formed. These auxiliary ribs 102f are disposed symmetrically apart from the middle position in the short side direction.

Some ribs are also formed on the inner surface of the case body 102 other than the above ribs, and a description of the ones which are not related particularly to a function of this embodiment is omitted.

Next, dispositions of various component parts in the case body 102 will be described.

### [Disposition of Inter-gap spacer]

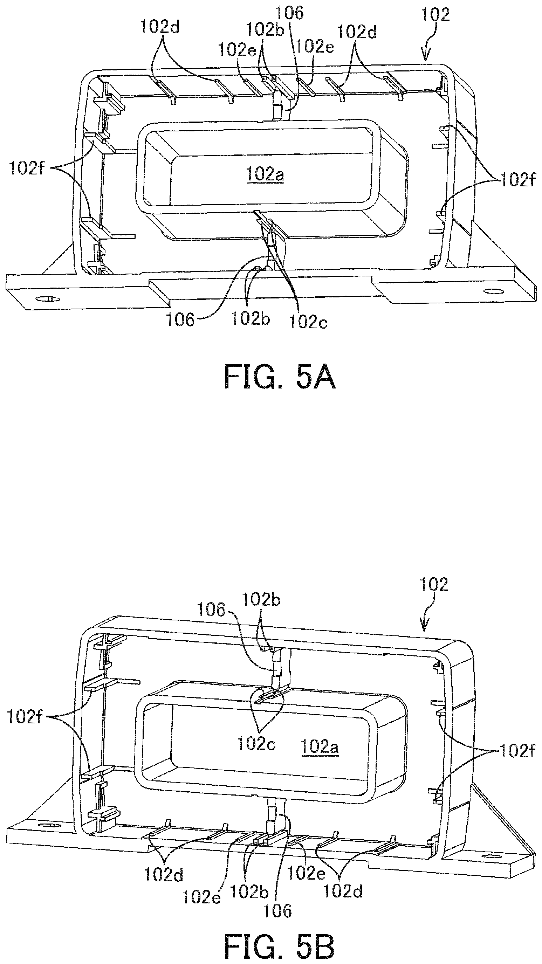

FIG. 5A and FIG. 5B are perspective views illustrating a disposition of the inter-gap spacers 106 in the case body 102. Similarly, also here, directions of obliquely viewing the case body 102 and the like are made different between FIG. 5A and FIG. 5B for convenience of visual recognition (similarly also subsequently to the above.).

The inter-gap spacers 106 are each disposed in a state of being inserted between the gap position ribs 102b, 102c each having two stripes, and their positions correspond to positions of the gaps 104c of the magnetic core 104. Note that regarding the gap position ribs 102c on the inner peripheral wall side, one edge portion of the inter-gap spacer 106 is fitted into a groove formed therebetween as described above.

### [Disposition of Magnetic core]

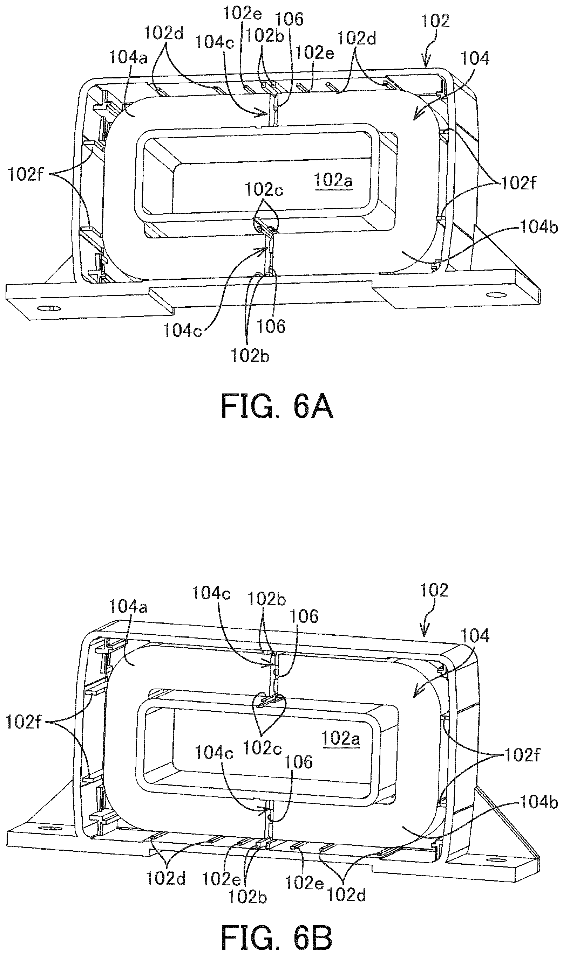

FIG. 6A and FIG. 6B are perspective views illustrating a disposition of the magnetic core 104 (core members 104a, 104b) in the case body 102.

The magnetic core 104 is disposed in the case body 102 in a state of facing end surfaces with each other in a state of sandwiching the inter-gap spacers 106 between the two core members 104a, 104b. At this time, the core members 104a, 104b are in a state of being housed in the case body 102 in a state where the outer peripheral surfaces are supported (or guided) by the above-mentioned many ribs (the gap position ribs 102b, the guide ribs 102d, the intermediate ribs 102e, the auxiliary ribs 102f, and so on). Note that inner peripheral surfaces of the core members 104a, 104b are supported (or guided) by the outer surface of the inner peripheral wall of the case body 102.

Here, it is as already described that the magnetic core 104 for the current sensor 100 is a factor greatly related to its sensing accuracy (characteristics, performance). For the magnetic core 104, it is very important that a distance of the gaps 104c is set properly as specified in advance and that the end surfaces of the core members 104a, 104b which sandwich the gaps 104c to face each other are disposed in a confronting manner in an actual disposition state, without saying the characteristics (magnetic permeability, hysteresis, and the like) of its material.

On this point, it can be said that the distance of the gaps 104c and the positional relationship of the end surfaces with each other only need to be inspected and controlled closely one by one by person's visual observation or the like in a mass production process, but it is not very realistic to provide such a process both in terms of man-hour and in an aspect of manufacturing costs. Accordingly, the quality is controlled on the premise of actually expecting a certain degree of variation, and even though the quality is controlled in this manner, variations are preferably suppressed to a minimum.

Thus, in this embodiment, by imparting the function of positioning to various component parts, the distance of the gaps 104c and the positional relationship of the end surfaces with each other are properly set. Hereinafter, the positioning of the core members 104a, 104b will be described.

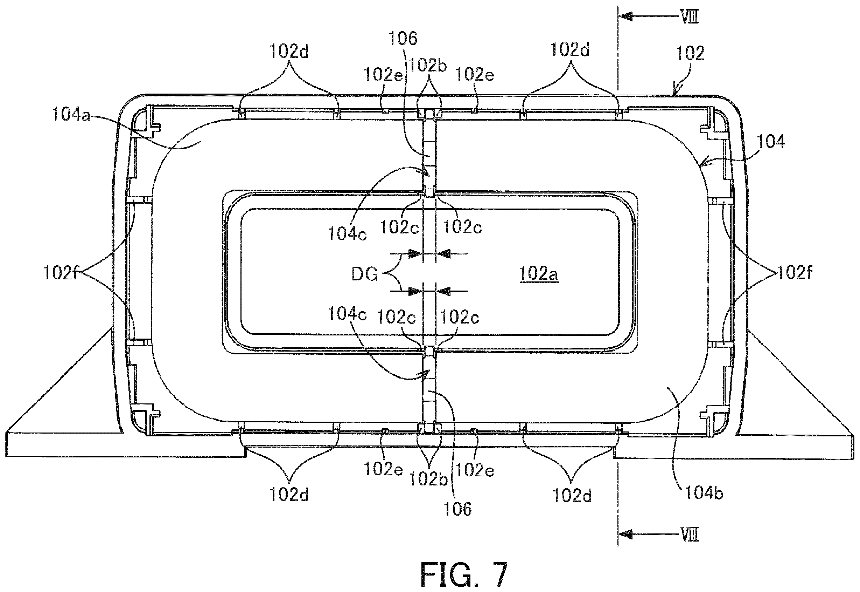

FIG. 7 is a front view illustrating the disposition of the magnetic core 104 housed in the case body 102. Note that here, the one end surface opening of the case body 102 is set as the front (similarly also subsequently to the above.).

In this state, the gaps 104c are formed in the spaces between the end surfaces of the core members 104a, 104b (two sections), and though the inter-gap spacers 106 are sandwiched in the gaps 104c, there is no confirmation that a gap distance DC has such a dimension as specified. That is, this is because between outer surfaces of the respective core members 104a, 104b, and, the inner surface of the case body 102 and the ribs, in both of the long side direction and the short side direction, there exists enough room (gap) for the respective core members 104a, 104b to cause a certain degree of displacement.

### [Positioning in short side direction]

On one hand, in a state illustrated in FIG. 7, the two core members 104a, 104b are already positioned in a state of properly facing the end surfaces present in each of two sections with each other. Such positioning is performed by positioning the core members 104a, 104b in the short side direction, and the positioning is achieved by the guide ribs 102d.

### [Guide part]

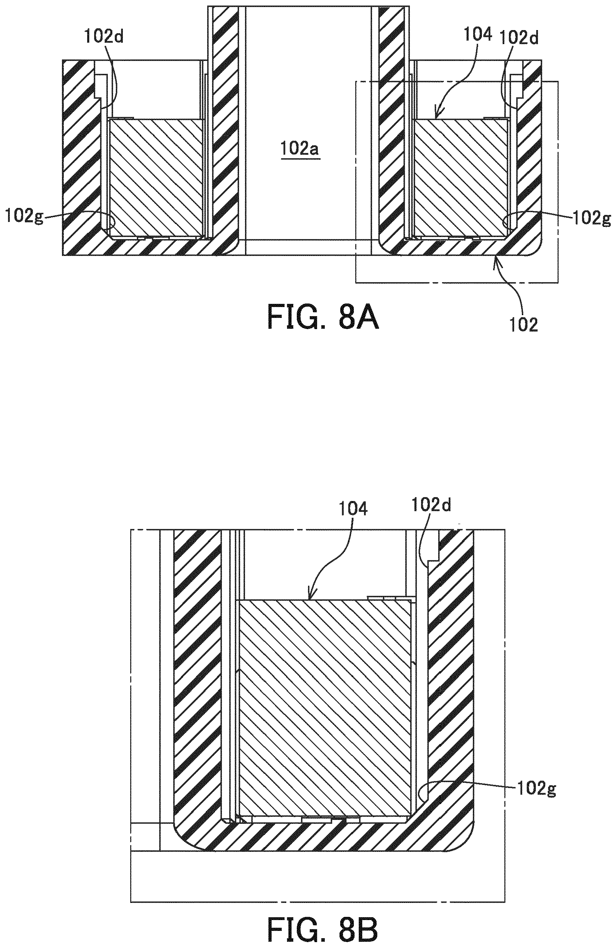

FIG. 8A and FIG. 8B are sectional views of the case body 120 and the magnetic core 104 which are taken along a VIII-VIII line in FIG. 7. FIG. 8A illustrates the entire cross section, and in FIG. 8B, a part thereof (a surrounding portion of a dot and dash line) is enlarged and illustrated.

The guide ribs 102d are formed so as to extend in a stripe shape on the inner surfaces of the outer peripheral wall of the case body 102 as described above, and at corner portions between the inner surfaces of the outer peripheral wall of the case body 102 and the other end surface thereof, inclined guide surfaces 102g each formed in a tapered shape are integrally formed across between the inner surfaces of the outer peripheral wall and the other end surface. Such inclined guide surfaces 102g are in positions of guiding (or supporting), in a housed state of the respective core members 104a, 104b, their outer peripheral edges.

At this time, a guide of the inclined guide surfaces 102g causes the respective core members 104a, 104b to approach the center in the short side direction, and they are positioned in the short side direction in the case body 102. This allows the two core members 104a, 104b to properly face the end surfaces facing each other. In observing the above between the end surfaces, the end surfaces are in a state of confronting each other along a magnetic flux path formed in the magnetic core 104.

### [Positioning in long side direction]

Next, positioning in the long side direction will be described. The positioning in the long side direction is achieved by the above-described positioning spacer 108.

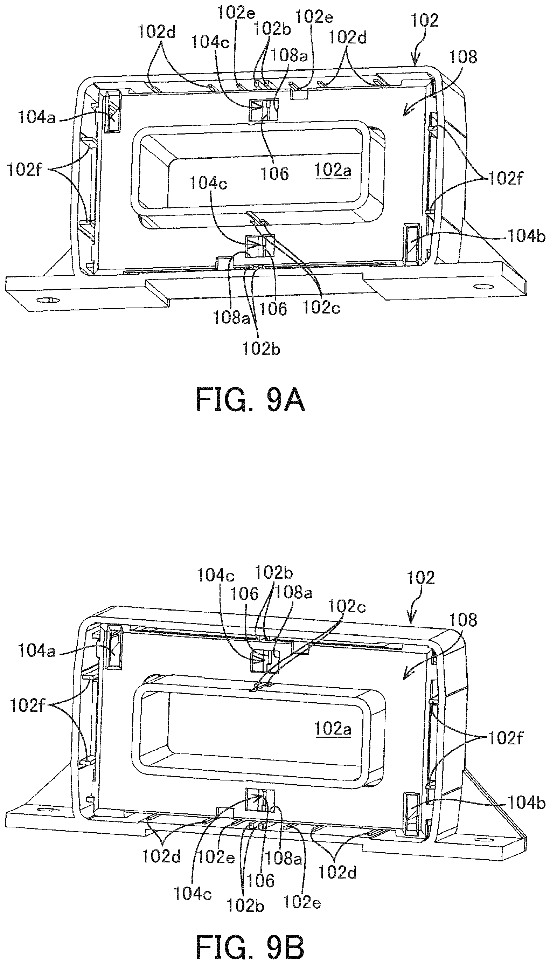

FIG. 9A and FIG. 9B are perspective views illustrating a disposition of the positioning spacer 108 with respect to the magnetic core 104 in the case body 102.

The positioning spacer 108 is housed in the case body 102 so as to cover the core members 104a, 104b from one side surface side thereof as described above. In this state, the positioning spacer 108 prevents the core members 104a, 104b from falling off the case body 102, and performs the positioning in the long side direction. Further, openings 108a at two sections of the positioning spacer 108 are in positions communicating with the respectively corresponding gaps 104c.

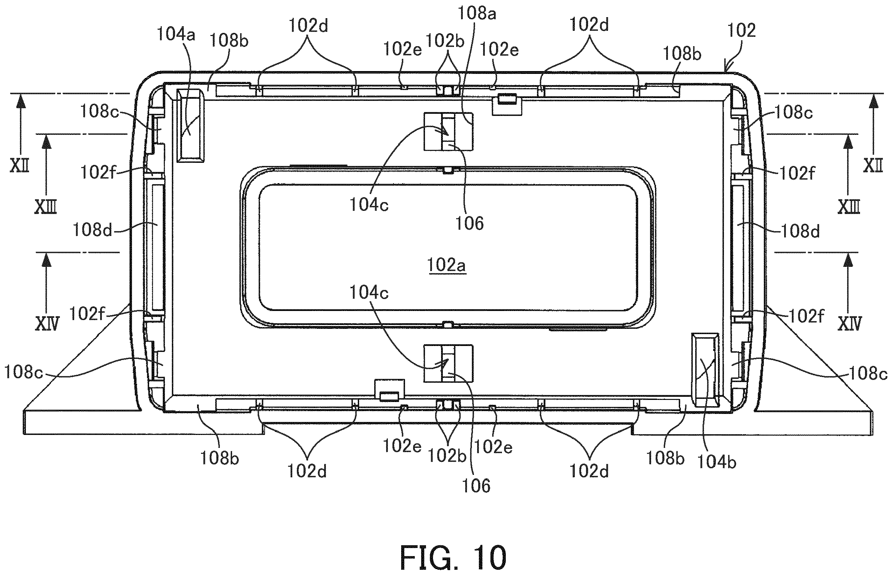

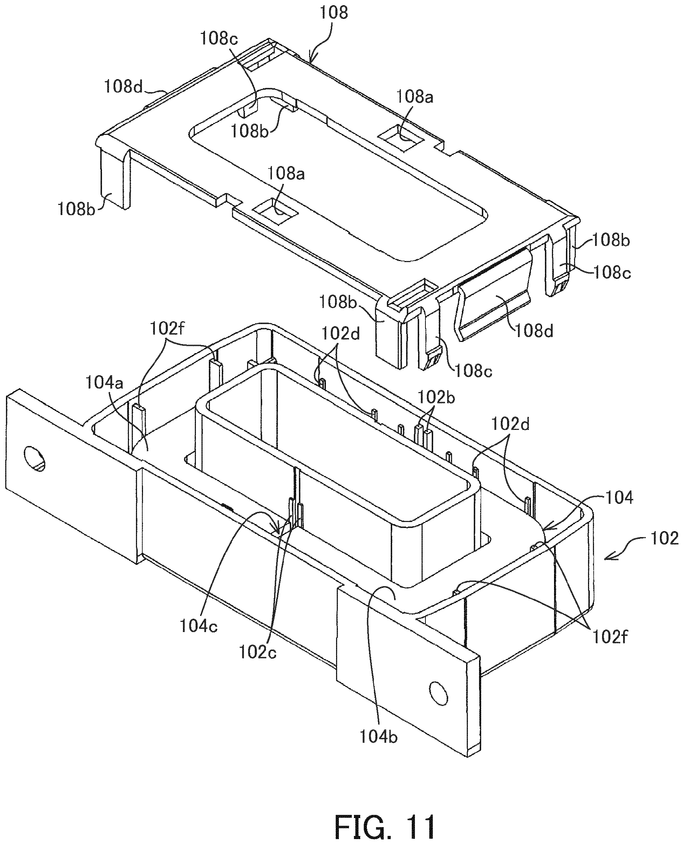

FIG. 10 is a front view illustrating the disposition of the positioning spacer 108 housed in the case body 102. Further, FIG. 11 is an exploded perspective view illustrating a state of separating the positioning spacer 108 from the case body 102 and the core members 104a, 104b.

The positioning spacer 108 has the leg portions 108b, the hooking claws 108c, and the spring portions 108d as described above. Among them, the leg portions 108b are each formed in a thin-sheet shape as a whole, and each have substantially constant thickness and width in an insertion direction. The hooking claws 108c are each formed in a boss shape in which a "return" is formed at a tip portion. The spring portions 108d are paired in the long side direction and each formed in a leaf-spring shape (clip shape), and a pair of these spring portions 108d can sandwich the two core members 104a, 104b therebetween to bias them in the facing directions.

In an assembly process of the current sensor 100, these leg portions 108b, hooking claws 108c, and spring portions 108d are inserted between the outer peripheral surfaces of the core members 104a, 104b and the inner surface of the case body 102 after housing the core members 104a, 104b. In such an insertion process, the leg portions 108b, the hooking claws 108b, and the spring portions 108d are inserted in sequence at time intervals, thereby fulfilling their respective specific functions. Hereinafter, the insertion process will be described.

### [Insertion of Leg portion]

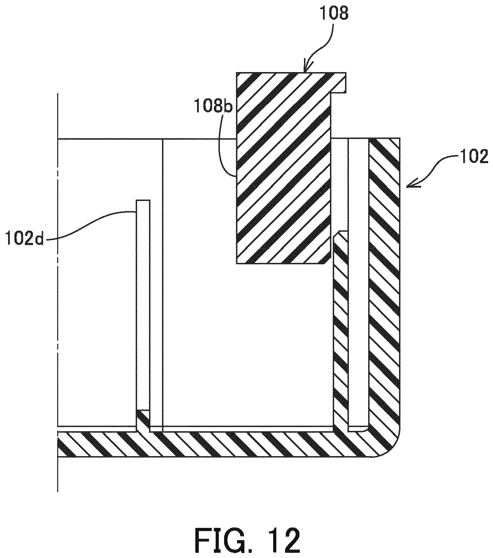

FIG. 12 is a sectional view of the case body 102 and the positioning spacer 108 (leg portion 108b) which is taken along a XII-XII line in FIG. 10.

In the insertion process of the positioning spacer 108, first, the tip portions of the leg portions 108b are inserted along the inner surface of the case body 102, and the insertion of the positioning spacer 108 is guided at four corners. This makes it possible to easily obtain an insertion start position of the positioning spacer 108 with respect to the one end surface opening of the case body 102 in the assembly process of the current sensor 100. Note that in the stage where the tip portions of the leg portions 108b are inserted in the initial stage of the insertion, the other hooking claws 108c and spring portions 108d are not brought into contact with the case body 102 and the core members 104a, 104b. Further, the leg portions 108b are brought into contact with the inner surface of the case body 102, but are not brought into contact with the core members 104a, 104b also after completion of the insertion.

### [Insertion of Hooking claw]

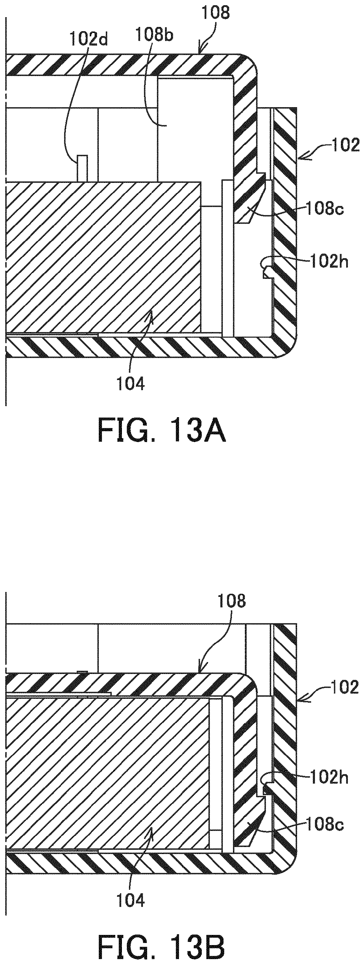

FIG. 13A and FIG. 13B are sectional views of the case body 102, the magnetic core 104, and the positioning spacer 108 (hooking claw 108c) which are taken along a XIII-XIII line in FIG. 10. FIG. 13A illustrates a state of the initial stage of the insertion, and FIG. 13B illustrates a state at a time of the insertion completion.

FIG. 13A: in the initial stage of the insertion, the hooking claw 108c is inserted subsequently to the leg portion 108b, but the hooking claw 108c does not particularly function in this stage. Note that the hooking claws 108c are not brought into contact with the core members 104a, 104b either.

FIG. 13B: on the inner surface of the case body 102, a protrusion-shaped hooking portion 102h is formed corresponding to a position where the hooking claw 108c is disposed, and the hooking claw 108c functions with the hooking portion 102h in a final stage of the insertion process. That is, in the final stage of the insertion process, the tip portions (return portions) of the hooking claws 108c are brought into contact with the hooking portions 102h, thereby bending (being elastically deformed) on the core member 104a, 104b sides. At this time, since the insertion start position of the positioning spacer 108 is determined in the initial stage of the insertion process, it becomes possible to stably control a bending load and a deflection amount to which the hooking claws 108c are subjected.

After this, when the tip portions (return portions) of the hooking claws 108c pass the hooking portions 102h accompanying the insertion, the hooking claws 108c are restored from a bending state, and the hooking portions 102h catch the tip portions (return portions). This prevents the positioning spacer 108 from falling off the case body 102, resulting in holding the core members 104a, 104b.

### [Insertion of Spring portion]

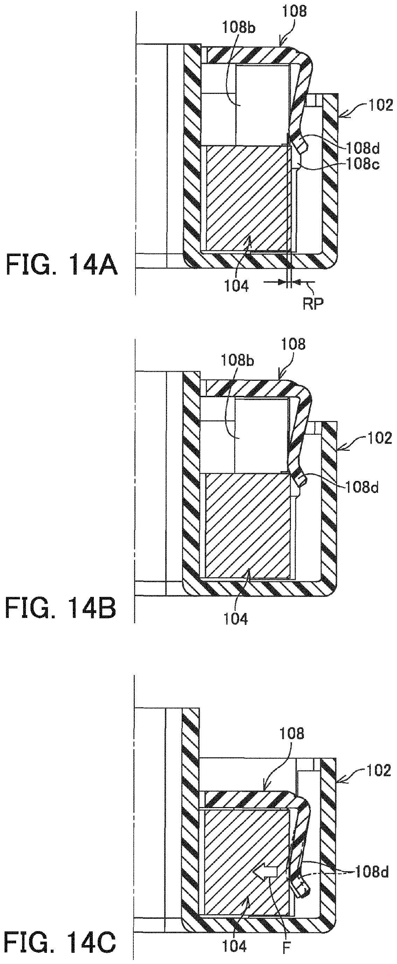

FIG. 14A to FIG. 14C are sectional views of the case body 102, the magnetic core 104, and the positioning spacer 108 (spring portion 108d) which are taken along a XIV-XIV line in FIG. 10. Here, the insertion process progresses in order of FIG. 14A → FIG. 14B → FIG. 14C.

FIG. 14A: the spring portion 108d extends so as to incline toward the center direction from its base end, and a tip portion is warped oppositely to each of the facing directions of the core members 104a, 104b. This warped portion enters the inside by an overlap RP from each of the outer peripheral edges of the core members 104a, 104b when seen in the long side direction. For this reason, in the insertion process, the warped portions of the spring portions 108d have a positional relationship of being brought into contact with the outer peripheral edges of the core members 104a, 104b.

FIG. 14B: when the insertion progresses, the warped portion in the spring portion 108d is brought into contact with each of the outer peripheral edges of the core members 104a, 104b. Similarly, also here, since the insertion start position of the positioning spacer 108 is determined in the initial stage of the insertion process, it becomes possible to stably control a bending load and a deflection amount to which the spring portions 108d are subjected.

After this, the insertion further progresses, and the spring portion 108d is thereby pushed by each of the outer peripheral edges of the core members 104a, 104b to bend (be elastically deformed) as a whole. When seen as a pair of both sides in the long side direction at this time, the spring portions 108d are bending-deformed so as to be widened to the outside.

FIG. 14C: in the completion state of the insertion, the spring portion 108d is in a state where the bending deformation to the outside in the long side direction remains as it is (which is illustrated by a solid line) when seen from its original natural state (illustrated by a two-dot chain line). At this time, the spring portion 108d biases each of the core members 104a, 104b in each of the directions facing each other by its restoring force, and each of the core members 104a, 104b is positioned by a biasing force F from the spring portion 108d. Note that in the insertion completion state of the positioning spacer 108, the spring portions 108d are each housed between the auxiliary ribs 102f.

### [Positioning in long side direction]

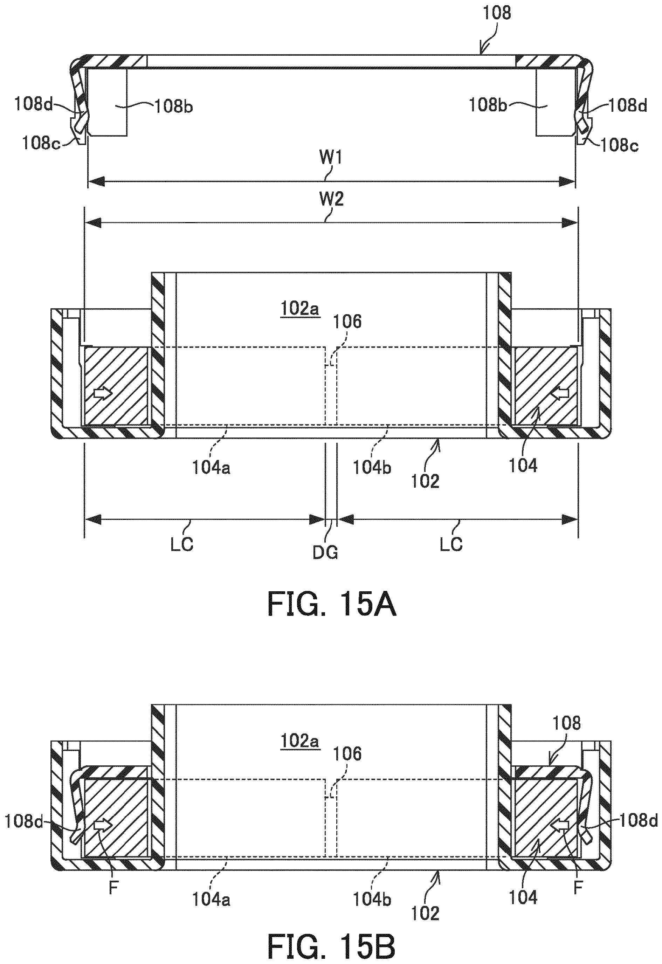

FIG. 15A and FIG. 15B are views explaining the positioning of the core members 104a, 104b by using the positioning spacer 108. Note that FIGs. 15 correspond to ones extending the cross sections illustrated from FIG. 14A to FIG. 14C in the long side direction.

FIG. 15A: in this embodiment, with respect to a pitch W1 between the pair of spring portions 108d of the positioning spacer 108, a full width W2 of the magnetic core 104 is set to be longer.

Here, the pitch W1 between the spring portions 108d is the shortest distance between the warped portions of the spring portions 108d as described above. Further, the full width W2 of the magnetic core 104 is a length of adding a regular distance DG of the gap 104c to one obtained by doubling a long-side direction dimension LC of each of the core members 104a, 104b. Note that the pitch W1 and the full width W2 may each have a certain degree of tolerance.

FIG. 15B: in a state of disposing the positioning spacer 108, the biasing forces F from the spring portions 108d act as described above, and the pair of core members 104a, 104b is positioned by being biased to each other in the directions facing each other. At this time, the core members 104a, 104b are securely positioned in the middle portion in the long side direction by sandwiching the inter-gap spacers 106 in the spaces between the facing end surfaces. This allows the gaps 104c to be properly set in the regular distance DG.

### [Disposition of Circuit board]

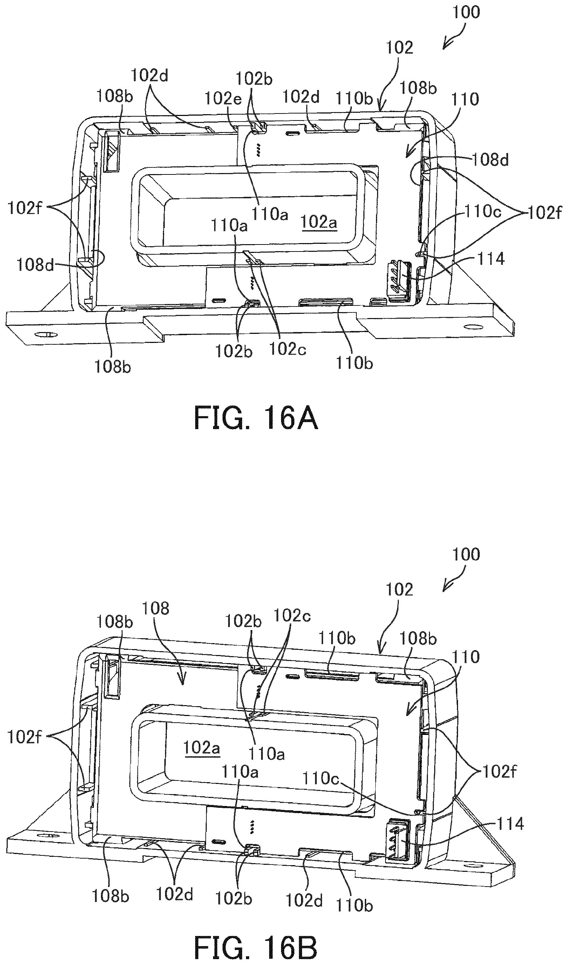

FIG. 16A and FIG. 16B are perspective views illustrating a disposition of the circuit board 110 in the case body 102.

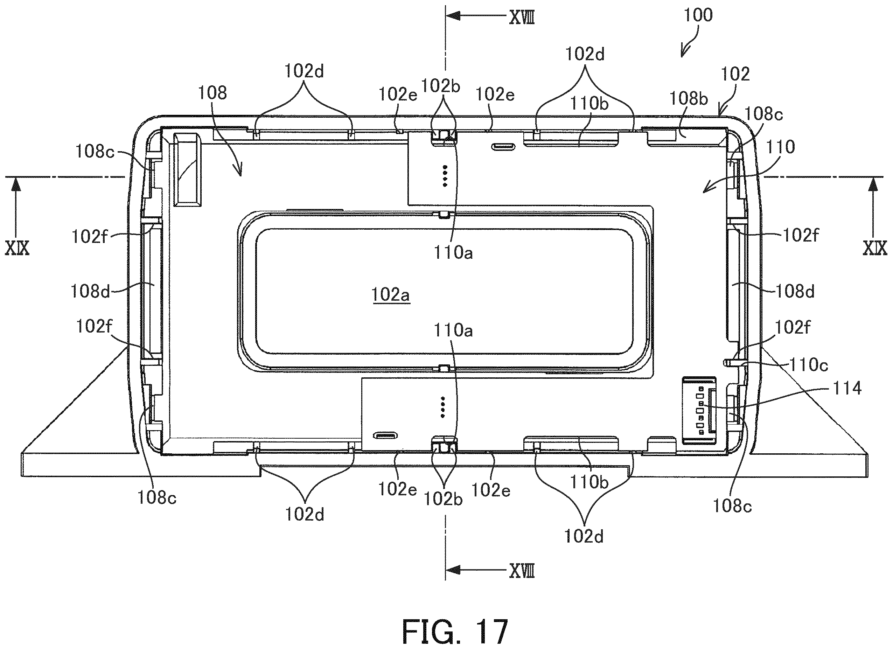

As described above, the circuit board 110, whose mounting surface has an outer shape formed in a ⊐ shape, is disposed in the case body 102 so as to be put on an outer surface of the positioning spacer 108 in the assembly state of the current sensor 100. Further, regarding the Hall elements 112 (not illustrated in FIG. 16A and FIG. 16B, FIG. 17), their magnetic sensitive portions (magnetic sensitive surfaces) are disposed through the openings 108a of the positioning spacer 108 in the gaps 104c.

Here, in order to make the Hall elements 112 perform sensing operation properly in the current sensor 100, it is necessary that the disposition of the Hall elements 112 (magnetic sensitive portions) in the gaps 104c is properly positioned. Since the Hall elements 112 are mounted on the circuit board 110, positions of the Hall elements 112 with respect to the circuit board 110 can be considered to be fixed. For this reason, in this embodiment, the circuit board 110 is regularly positioned with respect to the case body 102, thereby resulting in regularly positioning the positions of the Hall elements 112 (magnetic sensitive portions) in the gaps 104c.

### [Positioning of Circuit board]

FIG. 17 is a front view of the current sensor 100 including the circuit board 110. For positioning of the circuit board 110, the gap position ribs 102b and the auxiliary ribs 102f of the case body 102 are used. For this reason, in the circuit board 110, cutout portions 110a are formed in two sections of an outer edge portion, in addition to which a cutout portion 110c is formed in one section, and a position of each of the cutout portions 110a corresponds to positions of the gap position ribs 102b in the disposition state of the circuit board 110, and a position of the cutout portion 110c corresponds to a position of the auxiliary rib 102f. Note that in addition to this, in the outer edge portion of the circuit board 110, cutout portions 110b are formed.

Concretely, each two stripes of the gap position ribs 102b are arranged in the long side direction corresponding to each of the gaps 104c. The cutout portions 110a each corresponding to them each have a size capable of housing the entire arrangement of the two stripes of gap position ribs 102b therein. Further, the auxiliary ribs 102f are provided with two pairs formed on both sides in the long side direction, but one of them corresponds to the cutout portion 110c. The cutout portion 110c also has a size capable of housing the one corresponding auxiliary rib 102f therein. For this reason, in a state where the circuit board 110 is housed in the case body 102, the cutout portions 110a present in two sections are each in a state of housing the entire arrangement of gap position ribs 102b therein, and the cutout portion 110c in the one section is in a state of housing the one auxiliary rib 102f therein, and the circuit board 110 is thereby positioned regularly (in a specified position). This allows the Hall elements 112 to be positioned in regular positions in the gaps 104c without making the core members 104a, 104b, the inter-gap spacers 106, and the like interfere therewith (positioning means). Note that the auxiliary rib 102f and the cutout portion 110c may be omitted.

### [Degree of Freedom of Disposition]

In the circuit board 110, a change into a second disposition different from a first disposition illustrated in FIG. 17 is possible. Concretely, the circuit board 110 is rotated by 180° in a circumferential direction of the through hole 102a from the first disposition to obtain the second disposition (not illustrated). In the first disposition, the connector 114 is located at the right lower corner in a front view illustrated in FIG. 17, but in the second disposition, the connector 114 is located at the left upper corner. This makes it possible to select a position convenient for connection (wire routing) to the connector 114 according to an actual use environment of the current sensor 100.

Further, also in the second disposition, in the state where the cutout portions 110a present in two sections each house the entire arrangement of gap position ribs 102b therein as described above, the circuit board 110 can be regularly positioned.

As described above, in the housed state (mounted state) of the circuit board 110 into the case body 102, the circuit board 110 is regularly positioned, and both the two Hall elements 112 are thereby disposed properly into the corresponding gaps 104c. However, since the circuit board 110 is not positioned naturally in the assembly process (the stage before mounting) of the current sensor 100, it is not assured that the two Hall elements 112 confront the respective corresponding gaps 104c in the middle of work of housing the circuit board 110 in the case body 102 either, for example.

Thus, in the assembly process of the current sensor 100, in an attempt to mount the circuit board 110 in the state where the position is not yet fixed, the Hall elements 112 large protruding from the mounting surface are brought into contact with the sections other than the gaps 104c (the outer surface of the positioning spacer 108, the outer surfaces of the core members 104a, 104b, and the like), and have a possibility of suffering not a little damage (deformation such as bending lead terminals and all, damage of the element itself, or the like).

It can be naturally said to only need to be careful about assembly work and to adjust the positions of the Hall elements 112 or the like closely one by one by person's visual observation or the like before mounting the circuit board 110 in a mass production process, but it is not very realistic to provide such a process both in terms of man-hour and in an aspect of manufacturing costs.

Thus, in this embodiment, only in a case where the circuit board 110 confronts a regular mounting position with respect to the one end surface opening of the case body 102, a structure to permit the mounting (housing into the specified position) of the circuit board 110 is provided. Hereinafter, this point will be described.

### [Regulated condition of Housing (1)]

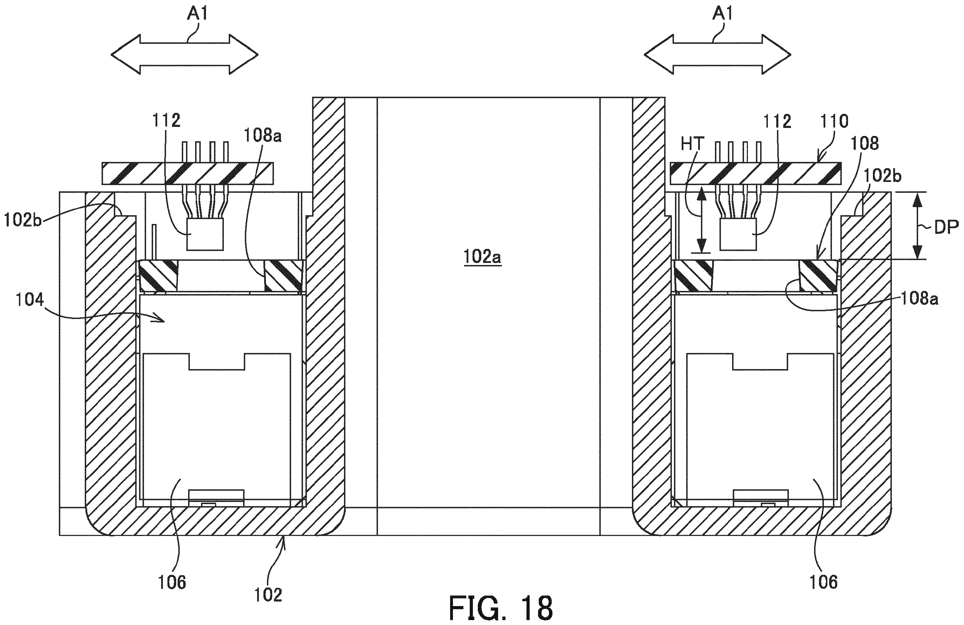

FIG. 18 is a view illustrating the circuit board 110 in the assembly process of the current sensor 100 in a state in the middle of mounting (a sectional view taken along a XVIII-XVIII line in FIG. 17.).

Naturally, the circuit board 110 before the housing into the case body 102, namely, in the middle of the mounting is not yet disposed in the regular position, and is not assured of certainly confronting the regular mounting position either. In the illustrated example, because the circuit board 110 deviates from the original mounting position in an arrow A1 direction in the view (short side direction) as a whole, the centers of the Hall elements 112 are biased in the arrow A1 direction further than the centers of the openings 108a.

In this embodiment, for example, as illustrated in FIG. 18, even though an attempt to house the circuit board 110 in the case body 102 is made while the circuit board 110 remains not confronting the regular mounting position, the circuit board 110 (mounting surface) is brought into contact with one end opening edge of the case body 102 to prevent the housing. In addition, even though the circuit board 110 is brought into contact with an opening edge of the case body 102, as compared with a mounting height HT of the Hall elements 112 here, a depth DP from the opening edge of the case body 102 to the outer surface of the positioning spacer 108 is set to be larger, and thus the Hall elements 112 do not interfere with the other components.

### [Time of Permitting Housing (1)]

Note that though not illustrated, as long as the circuit board 110 is properly housed in the case body 102 from the state illustrated in FIG. 18, a worker and a work machine are required to correct the circuit board 110 in a state of confronting the regular mounting position. Based on the above, the Hall elements 112 only passing through a path not to interfere with the outer surfaces of the positioning spacer 108 and the core members 104a, 104b permits the circuit board 110 to be housed in the case body 102.

### [Regulated condition of Housing (2)]

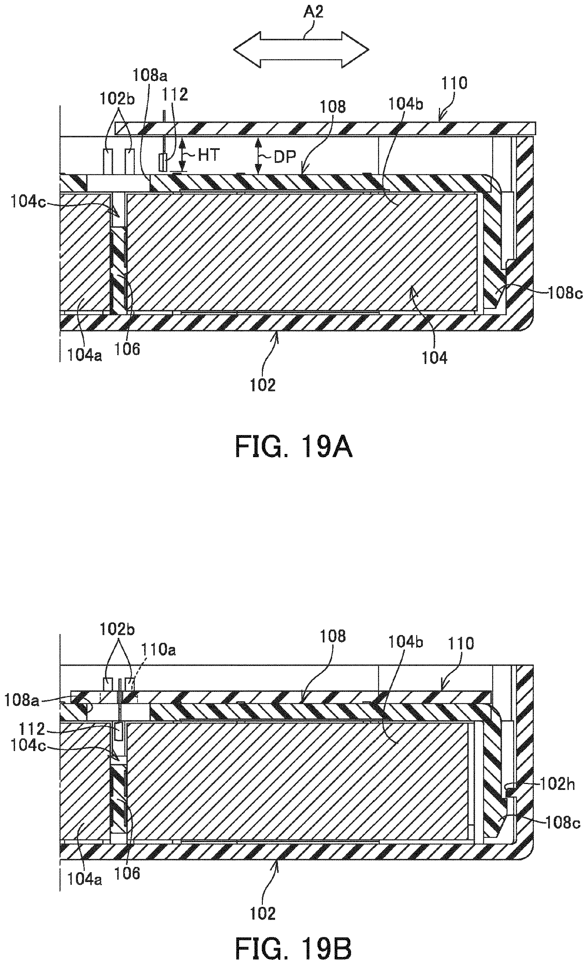

FIG. 19A and FIG. 19B are views illustrating the circuit board 110 in the assembly process of the current sensor 100 in the state in the middle of the mounting from a direction different from that in FIG. 18 (sectional views taken along a XIX-XIX line in FIG. 17).

### [Time of Regulating Housing]

FIG. 19A: for example, even though the circuit board 110 does not confront the regular mounting position, and an attempt to house the circuit board 110 in the case body 102 is made while a position remains deviating in the long side direction of the case body 102 (an arrow A2 direction in the view), the circuit board 110 (mounting surface) is brought into contact with the one end opening edge of the case body 102 to prevent the housing after all. Further, similarly, even though the circuit board 110 is brought into contact with the opening edge of the case body 102, as compared with the mounting height HT of the Hall element 112, the depth DP from the opening edge of the case body 102 to the outer surface of the positioning spacer 108 is set to be larger, and thus the Hall element 112 does not interfere with the other components after all.

### [Time of Permitting Housing (2)]

FIG. 19B: thereafter, when the worker and the work machine cause the circuit board 110 to confront the regular mounting position, only passing through a regular path going toward the mounting position from the above state permits the circuit board 110 to be housed in the case body 102. Only passing through such a regular path permits the housing (mounting work) of the circuit board 110, thereby making it possible to securely prevent the Hall elements 112 from interfering with the outer surfaces of the positioning spacer 108 and the core members 104a, 104b and suffering damage.

Note that the above-described example indicates a case where the circuit board 110 is biased in either direction (arrows A1, A2), but similarly also in a case of being biased in both directions in a composite manner, the housing of the circuit board 110 in the case body 102 is regulated from such a state as described above.

In any case, in this embodiment, in the assembly process of the current sensor 100, the housing of the circuit board 110 into the case body 102 is permitted only by passing through the regular path not to cause the interference between the Hall elements 112 and the other components. This makes it possible to retain quality of the current sensor 100 after completion without the Hall elements 112 suffering damage in the assembly process.

According to the current sensor 100 of the above-mentioned embodiment, the following superiority can be obtained.
(1) When the plurality of core members 104a, 104b compose the magnetic core 104, structurally, variations in positional accuracy of each of the core members 104a, 104b make it difficult to make the distance of the gaps 104c close to a required value, but in this embodiment, since the two core members 104a, 104b are positioned by being biased in the directions facing each other by the spring portions 108d of the positioning spacer 108, the inter-gap spacers 106 sandwiched in the spaces between the end surfaces can maintain the gap distance while remaining close to the required value.
(2) The bias and the positioning by using the positioning spacer 108 act effectively also after production shipment, and thus, even though there is an influence of a use environment (for example, temperature changes or the like) of the current sensor 100, the biasing force from the spring portions 108d acts in the directions of maintaining the gap distance at the required value, which thus allows the sensing accuracy to be maintained over a long time.
(3) Since the positioning spacer 108 is only mounted so as to cover the core members 104a, 104b from the outside of the case body 102 after mounting them, workability is high and the core members 104a, 104b can be properly positioned by only simple and easy work.
(4) Since the positioning spacer 108 is provided with a function (leg portions 108d) of positioning itself in the insertion start position into the one end surface opening of the case body 102, it is possible to stabilize conditions (position and angle) under which the hooking claws 108c and the spring portions 108d are brought into contact with the hooking portions 102h and the core members 104a, 104b at the time of mounting. This makes it possible to easily control the bending load and the deflection amount to which the hooking claws 108c and the spring portions 108d are subjected, and to securely prevent damage or the like at a time of assembly work.
(5) Further, only housing the core members 104a, 104b in the case body 102 causes the guide ribs 102d to subject the core members 104a, 104b to selfalignment in the middle position in the short side direction, and thus, the worker and the work machine need not care about the positioning one by one, which further improves the workability.
(6) On the occasion of the mounting work (housing into the case body 102) of the circuit board 110, since the mounting from an improper path which is not regular is regulated, the worker and the work machine are unlikely to accidentally damage electronic components such as the Hall elements 112.
(7) Conversely, there is no problem even though the worker or the like performs trial and error by groping about the regular path to permit the mounting of the circuit board 110, and as long as the mounting of the circuit board 110 is permitted, it is a regular mounting path, and thus, it is possible to complete the work easily and securely without particularly paying attention.
(8) This enables improvement in production efficiency of the current sensor 100 and reduction in cost.

The present invention can be variously modified and embodied without being limited to the one above-mentioned embodiment. For example, an overall shape of the current sensor 100 may be other than the rectangular annular shape. Further, the inside of the housing space of the case body 102 may be in a form to be filled with a sealing resin or the like in a state of housing the magnetic core 104, the inter-gap spacers 106, the positioning spacer 108, the circuit board 110 and so on. Also in this case, since the positioning using the biasing force caused by the positioning spacer 108 acts effectively, it is possible to compensate an influence due to volume changes of the filling resin, or the like and maintain the distance of the gaps 104c over a long time.

The case body 102 may have a form divided into a plurality of parts, or may be provided with an opening/closing lid body. Further, a shape of the case body 102 and disposition of the ribs (the gap position ribs 102b, 102c, the guide ribs 102d, the intermediate ribs 102e, the auxiliary ribs 102f, and so on) can be appropriately deformed according to the shape of the core members 104a, 104b to be used, and the number of them is not limited to that in the example cited in the embodiment either.

The magnetic core 104 has the gaps 104c at the middle position in the long side direction, but may have the gap 104c at another position. Further, the number of gaps 104c may be more than two. Also in this case, the positioning is performed while being biased in the facing directions by the positioning spacer 108, thereby allowing the distance of the respective gaps 104c to be properly maintained.

In the embodiment, as one example of the magnetic core 104, there is cited the one composed of the two-divided type core members 104a, 104b, but a magnetic core which is constituted by stacking a plurality of plate-shaped core members may be used. In this case, in the positioning using the spring portions of the positioning spacer, the positioning can be performed while biasing the plate-shaped core members in a direction of stacking each other in a state of stacking them, for example.

The positioning of the circuit board 110 may be performed by using a means other than the fitting of the gap position ribs 102b and the cutout portion 110a. For example, positioning-dedicated ribs may be formed in the case body 102 separately, to form a cutout portion corresponding to them in the circuit board 110. Further, a protrusion-shaped portion is protruded to be formed on the outer edge of the circuit board 110, and a recessed portion capable of housing it may be formed in the case body 102 to be set as a positioning means. In addition, the sections of positioning may be more than three.

Besides, the structures cited with the illustration in the embodiment or the like are only a suitable example.

## Claims

1. A current sensor (100) comprising: a plurality of core members (104a, 104b) which form a converging path of a magnetic field generated by continuity of a current to be sensed by providing gaps (104c) in respective spaces between end surfaces facing each other in a plurality of sections to be disposed in an annular shape; and a case body (102) which disposes and houses the plurality of core members (104a, 104b) in an annular shape,
**characterized in that** the current sensor (100) comprises a positioning member (108) which positions the plurality of core members (104a, 104b) in predetermined positions where the gaps (104c) are held in a specified distance by pressing the plurality of core members (104a, 104b) oneach other in directions facing each other by restoring force in directions opposite to elastic deformation of portions (108d) brought into contact with the plurality of core members (104a, 104b) by being inserted into the case body (102), and elastically deformed by the contact.

2. The current sensor (100) according to claim 1,
**characterized in that** the current sensor (100) further comprises holding members (106) which hold the gaps (104c) in the specified distance by being sandwiched in the spaces between the end surfaces of the plurality of core members (104a, 104b) in a state of being pressed by the positioning member (108).

3. The current sensor (100) according to claim 1 or 2,
**characterized in that** the case body (102) has guide parts (102g) which position the plurality of core members (104a, 104b) in directions crossing the facing directions and confront the end surfaces with each other along the converging path, while guiding the plurality of core members (104a, 104b) at outer peripheral edges accompanying housing of the plurality of core members (104a, 104b).

4. The current sensor (100) according to any one of claims 1 to 3,
**characterized in that** the positioning member (108) positions the core members (104a, 104b) in a state of being housed in the case body (102) with the plurality of core member (104a, 104b).

5. The current sensor (100) according to any one of claims 1 to 4,
**characterized in that**:
the current sensor (100) further comprises a circuit board (110) housed in the case body (102) with the plurality of core members (104a, 104b), and formed with a circuit to sense the current to be sensed by using output signals from magnetic sensing elements (112) to be disposed in the gaps (104c); and
the positioning member (108) positions the plurality of core members (104a, 104b) with positions where the magnetic sensing elements (112) mounted on the circuit board (110) are disposed in predetermined positions in the gaps (104c) set as the predetermined positions.

## Patentansprüche

1. Stromsensor (100), umfassend: eine Vielzahl von Kernelementen (104a, 104b), die einen konvergierenden Pfad eines Magnetfeldes bilden, das durch Kontinuität eines zu erfassenden Stroms erzeugt wird, indem Lücken (104c) in jeweiligen Räumen zwischen Stirnflächen, die einander zugewandt sind, in einer Vielzahl von Abschnitten bereitgestellt werden, die in einer Ringform angeordnet werden sollen; und einen Gehäusekörper (102), der die Vielzahl von Kernelementen (104a, 104b) in einer Ringform anordnet und aufnimmt,
**dadurch gekennzeichnet, dass** der Stromsensor (100) ein Positionierungselement (108) umfasst, das die Vielzahl von Kernelementen (104a, 104b) in vorbestimmten Positionen positioniert, in denen die Lücken (104c) in einem festgelegten Abstand gehalten werden, indem die Vielzahl von Kernelementen (104a, 104b) in einander zugewandten Richtungen durch eine Rückstellkraft in Richtungen, die der elastischen Verformung von Abschnitten (108d) entgegengesetzt sind, die mit der Vielzahl von Kernelementen (104a, 104b) in Kontakt gebracht werden, indem sie in den Gehäusekörper (102) eingeführt und durch den Kontakt elastisch verformt werden, aufeinander gedrückt werden.

2. Stromsensor (100) nach Anspruch 1,
**dadurch gekennzeichnet, dass** der Stromsensor (100) weiter Halteelemente (106) umfasst, die die Lücken (104c) in dem festgelegten Abstand halten, indem sie in den Räumen zwischen den Stirnflächen der Vielzahl von Kernelementen (104a, 104b) in einem Zustand eingelegt sind, in dem sie von dem Positionierungselement (108) gedrückt werden.

3. Stromsensor (100) nach Anspruch 1 oder 2,
**dadurch gekennzeichnet, dass** der Gehäusekörper (102) Führungsteile (102g) aufweist, die die Vielzahl von Kernelementen (104a, 104b) in Richtungen positionieren, die die einander zugewandten Richtungen kreuzen, und die Stirnflächen einander entlang des konvergierenden Pfades gegenüberstellen, während sie die Vielzahl von Kernelementen (104a, 104b) an äußeren Umfangskanten führen, die die Aufnahme der Vielzahl von Kernelementen (104a, 104b) begleiten.

4. Stromsensor (100) nach einem der Ansprüche 1 bis 3,
**dadurch gekennzeichnet, dass** das Positionierungselement (108) die Kernelemente (104a, 104b) in einem Zustand positioniert, in dem sie in dem Gehäusekörper (102) mit der Vielzahl von Kernelementen (104a, 104b) aufgenommen sind.

5. Stromsensor (100) nach einem der Ansprüche 1 bis 4,
**dadurch gekennzeichnet, dass**:
der Stromsensor (100) weiter eine Leiterplatte (110) umfasst, die in dem Gehäusekörper (102) mit der Vielzahl von Kernelementen (104a, 104b) aufgenommen ist und mit einer Schaltung zum Erfassen des zu erfassenden Stroms unter Verwendung von Ausgangssignalen von in den Lücken (104c) anzuordnenden magnetischen Erfassungselementen (112) ausgebildet ist; und
das Positionierungselement (108) die Vielzahl von Kernelementen (104a, 104b) positioniert, wobei Positionen, in denen die auf der Leiterplatte (110) montierten magnetischen Erfassungselemente (112) in vorbestimmten Positionen in den Lücken (104c) angeordnet sind, als die vorbestimmten Positionen festgelegt sind.

## Revendications

1. Capteur de courant (100) comprenant : une pluralité d'éléments de noyau (104a, 104b) qui forment un chemin convergent d'un champ magnétique généré par la continuité d'un courant à détecter en ménageant des vides (104c) dans des espaces respectifs entre des surfaces d'extrémité se faisant face les unes aux autres dans une pluralité de sections à disposer dans une forme annulaire ; et un corps de boîtier (102) qui dispose et loge la pluralité d'éléments de noyau (104a, 104b) sous une forme annulaire,
**caractérisé en ce que** le capteur de courant (100) comprend un élément de positionnement (108) qui positionne la pluralité d'éléments de noyau (104a, 104b) dans des positions prédéterminées où les vides (104c) sont maintenus à une distance spécifiée en pressant la pluralité d'éléments de noyau (104a, 104b) les uns sur les autres dans des directions se faisant face les uns aux autres par une force de rappel dans des directions opposées à la déformation élastique de parties (108d) mises en contact avec la pluralité d'éléments de noyau (104a, 104b) en étant insérées dans le corps de boîtier (102), et déformées élastiquement par le contact.

2. Capteur de courant (100) selon la revendication 1,
**caractérisé en ce que** le capteur de courant (100) comprend en outre des éléments de maintien (106) qui maintiennent les vides (104c) à la distance spécifiée en étant pris en sandwich dans les espaces entre les surfaces d'extrémité de la pluralité d'éléments de noyau (104a, 104b) dans un état où ils sont pressés par l'élément de positionnement (108).

3. Capteur de courant (100) selon la revendication 1 ou 2,
**caractérisé en ce que** le corps de boîtier (102) a des parties de guidage (102g) qui positionnent la pluralité d'éléments de noyau (104a, 104b) dans des directions croisant les directions opposées et confrontent les surfaces d'extrémité les unes avec les autres le long du chemin convergent, tout en guidant la pluralité d'éléments de noyau (104a, 104b) au niveau des bords périphériques extérieurs accompagnant le logement de la pluralité d'éléments de noyau (104a, 104b).

4. Capteur de courant (100) selon l'une quelconque des revendications 1 à 3,
**caractérisé en ce que** l'élément de positionnement (108) positionne les éléments de noyau (104a, 104b) dans un état où il est logé dans le corps de boîtier (102) avec la pluralité d'éléments de noyau (104a, 104b).

5. Capteur de courant (100) selon l'une quelconque des revendications 1 à 4,
**caractérisé en ce que** :
le capteur de courant (100) comprend en outre une carte de circuit imprimé (110) logée dans le corps de boîtier (102) avec la pluralité d'éléments de noyau (104a, 104b), et formée avec un circuit pour détecter le courant à détecter en utilisant des signaux de sortie à partir d'éléments de détection magnétiques (112) devant être disposés dans les vides (104c) ; et
l'élément de positionnement (108) positionne la pluralité d'éléments de noyau (104a, 104b) avec des positions où les éléments de détection magnétiques (112) montés sur la carte de circuit imprimé (110) sont disposés dans des positions prédéterminées dans les vides (104c) définis comme les positions prédéterminées.
